# EUROPÄISCHE PATENTSCHRIFT

(11) **EP 1 590 832 B1**
(45) Veröffentlichungstag und Bekanntmachung des Hinweises auf die Patenterteilung: **18.11.2009**
(21) Anmeldenummer: 04707864.7
(22) Anmeldetag: 04.02.2004
(51) Int. Cl.: H01L 27/115, H01L 21/8247, H01L 21/336, H01L 29/788, H01L 21/8246, H01L 21/74

(54) **SPEICHERZELLE, SPEICHERZELLEN-ANORDNUNG UND VERFAHREN ZUM HERSTELLEN EINER SPEICHERZELLE**
STORAGE CELL, STORAGE CELL ARRANGEMENT, AND METHOD FOR THE PRODUCTION OF A STORAGE CELL
CELLULE DE MEMOIRE, SYSTEME DE CELLULES DE MEMOIRE ET PROCEDE DE FABRICATION D'UNE CELLULE DE MEMOIRE

(30) Priorität: 05.02.2003 DE 10304654
(43) Veröffentlichungstag der Anmeldung: 02.11.2005
(73) Patentinhaber: Infineon Technologies AG, 81669 München (DE)
(72) Erfinder: SCHULER, Franz, D-85586 Poing (DE)
(74) Vertreter: Viering, Jentschura & Partner
(86) Internationale Anmeldenummer: PCT/DE2004/000186
(87) Internationale Veröffentlichungsnummer: WO 2004/070841

(56) Entgegenhaltungen:
- EP-A- 0 073 370
- US-A- 5 515 319
- US-A- 6 078 074

## Beschreibung

Die Erfindung betrifft eine Speicherzelle, eine Speicherzellen-Anordnung und ein Verfahren zum Herstellen einer Speicherzelle.

Angesichts der schnellen Entwicklung in der Computertechnologie besteht ein Bedarf an immer schnelleren, dichteren und besser programmierbaren, löschbaren und lesbaren Speicherzellen.

Aus dem Stand der Technik ist eine nichtflüchtige sogenannte CHE-Speicherzelle ("Channel Hot Electron") bekannt, die einen Feldeffekttransistor mit einer elektrisch leitfähigen Floating-Gate-Schicht zwischen Gate-isolierender Schicht und Steuergate aufweist. Mittels Injizierens heißer Kanal-Elektronen werden in diese Speicherzelle elektrische Ladungsträger eingebracht. In der Anwesenheit/Abwesenheit von Ladungsträgern in der Floating-Gate-Schicht ist die in der Speicherzelle speicherbare Information kodiert. Bei einer CHE-Speicherzelle können "heiße", das heißt ausreichend stark beschleunigte, Elektronen oder Löcher in der Nähe eines Drain-Bereichs durch die Gate-isolierende Schicht hindurch in die Floating-Gate-Schicht gelangen. Aufgrund eines das Floating-Gate umgebenden elektrisch isolierenden Bereichs sind die eingebrachten elektrischen Ladungsträger vor einem Abfließen aus der Floating-Gate-Schicht geschützt und verbleiben somit dauerhaft in der Floating-Gate-Schicht.

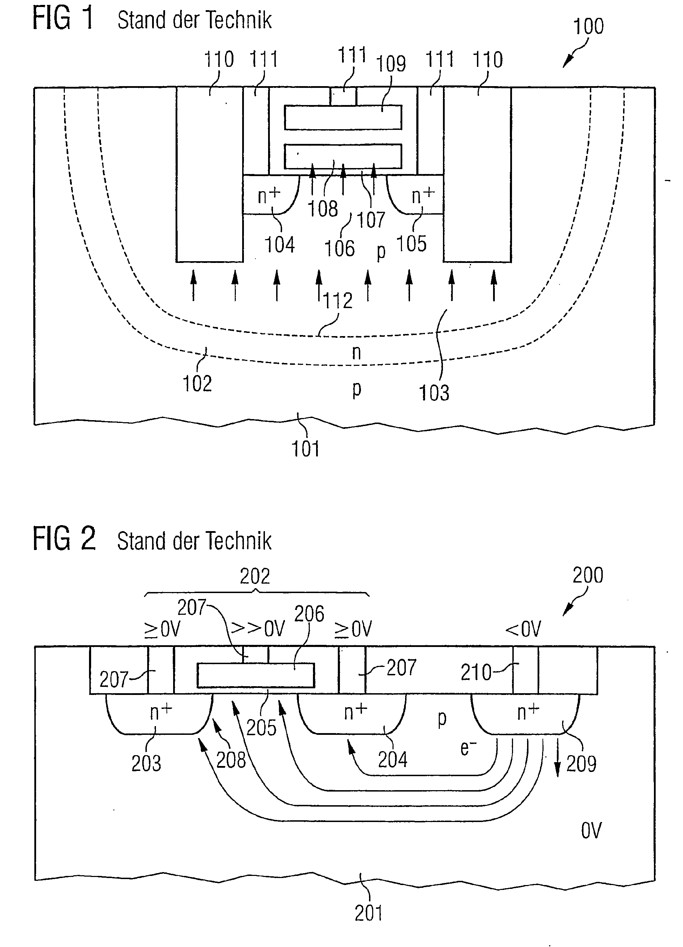

Im Weiteren wird bezugnehmend auf **Fig.1** eine aus dem Stand der Technik bekannte Floating-Gate-Speicherzelle 100 beschrieben.

Die Floating-Gate-Speicherzelle 100 ist in einem p-dotierten Silizium-Substrat 101 integriert. In dem p-dotierten Silizium-Substrat 101 ist eine n-dotierte Wanne 102 gebildet. In der n-dotierten Wanne 102 ist eine p-dotierte Wanne 103 gebildet. In einem ersten Oberflächenbereich der p-dotierten Wanne 103 ist ein erster Source-/Drain-Bereich 104 als n⁺-dotierter Bereich gebildet. Ferner ist in einem zweiten Oberflächenbereich der p-dotierten Wanne 103 ein zweiter Source-/Drain-Bereich 105 als n⁺-dotierter Bereich gebildet. In dem Oberflächenbereich der p-dotierten Wanne 103 zwischen den Source-/Drain-Bereichen 104, 105 ist ein Kanal-Bereich 106 gebildet. Mittels eines elektrisch isolierenden Bereichs 107 ist ein über dem Kanal-Bereich 106 angeordneter Floating-Gate-Bereich 108 von dem Kanal-Bereich 106 elektrisch isoliert, und ist ein über dem Floating-Gate-Bereich 108 angeordnetes Steuergate 109 von dem Floating-Gate-Bereich 108 elektrisch isoliert. Mittels seitlich der Floating-Gate-Speicherzelle 101 angeordneter STI-Bereiche 110 ("Shallow Trench Isolation") ist die Floating-Gate-Speicherzelle 100 von benachbarten Speicherzellen (nicht gezeigt in Fig.1) einer Speicherzellen-Anordnung elektrisch entkoppelt. Mittels Kontaktierungselementen 111 kann an die Source-/Drain-Bereiche 104, 105 und an das Steuergate 109 jeweils ein vorgebbares elektrisches Potential angelegt werden.

Zwischen der n-dotierten Wanne 102 und der p-dotierten Wanne 103 ist ein pn-Übergang 112 gebildet.

Zum Einbringen von elektrischen Ladungsträgern in das Floating-Gate 108 der nichtflüchtigen Floating-Gate-Speicherzelle 100 werden heiße Elektronen aus dem Substrat unter Verwendung eines elektrisch in Vorwärtsrichtung vorgespannten pn-Übergangs 112 injiziert. Hierfür wird das Steuergate 109 auf ein positives elektrisches Potential ausreichend großen Betrags gebracht. Aufgrund der (kapazitiven) Kopplung des Floating Gates 108 and das SteuerGate 109 wirkt dieses elektrische Potential auch auf das Floating-Gate 108. Der pn-Übergang 112 zwischen der n-dotierten Wanne 102 und der p-dotierten Wanne 103 wird derart elektrisch vorgespannt, dass Elektronen aus der n-dotierten Wanne 102 in die p-dotierte Wanne 103 injiziert werden. Aufgrund des positiven Potentials an dem Floating-Gate 108 werden Elektronen zu dem Kanal-Bereich 106 beschleunigt und können durch die mittels des elektrisch isolierenden Bereichs 107 gebildete Gate-isolierende Schicht in das Floating-Gate 108 injiziert werden. Dadurch kann eine Information in die Speicherzelle 100 programmiert werden.

Allerdings weist die in Fig.1 gezeigte Floating-Gate-Speicherzelle 100 den Nachteil auf, dass der gesamte pn-Übergang 112 über eine große laterale Breite hinweg vorgespannt werden muss. Dies führt zu einem hohen Energieverbrauch beim Programmieren, Löschen und Lesen der Speicherzelle 100, was insbesondere für Low-Power-Anwendungen nachteilhaft ist.

Im Weiteren wird bezugnehmend auf **Fig.2** eine Test-Anordnung 200 beschrieben, die für Untersuchungen der Zuverlässigkeit von Bauelementen bekannt ist. Insbesondere dient die Test-Anordnung 200 dazu, die Güte bzw. Zuverlässigkeit einer Gate-isolierenden Schicht in einem zuvor ausgebildeten Feldeffekttransistor zu überprüfen.

Die Test-Anordnung 200 ist auf und in einem p-dotierten Silizium-Substrat 201 integriert. Insbesondere ist in der Test-Anordnung 200 ein Feldeffekttransistor 202 integriert. Dieser enthält einen in einem ersten Oberflächenbereich des p-dotierten Silizium-Substrats 201 gebildeten ersten Source-/Drain-Bereich 203 und einen in einem zweiten Oberflächenbereich des p-dotierten Silizium-Substrats 201 gebildeten zweiten Source-/Drain-Bereich 204. Beide Source-/Drain-Bereiche 203, 204 sind n⁺-dotierte Bereiche. Zwischen den beiden Source-/Drain-Bereichen 203, 204 ist ein Kanal-Bereich 208 gebildet. Oberhalb des Kanal-Bereichs 208 ist ein Gate-Bereich 206 gebildet, der von dem Kanal-Bereich 208 mittels einer Gate-isolierenden Schicht, die Teil eines elektrisch isolierenden Bereichs 205 ist, elektrisch getrennt ist. Ferner sind Kontaktierungselemente 207 zum Anlegen definierter elektrischer Potentiale an die Source-/Drain-Bereiche 203, 204 bzw. an den Gate Bereich 206 vorgesehen. Seitlich des Feldeffekttransistors 202 ist in einem anderen Oberflächenbereich des Silizium-Substrats 201 ein zusätzlicher n⁺-dotierter Bereich 209 vorgesehen, welcher mittels eines anderen Kontaktierungselements 210 elektrisch ansteuerbar ist. Wie in Fig.2 schematisch angedeutet, .können mittels Anlegens von 0V oder eines positiven elektrischen Potentials an die Source-/Drain-Bereiche 203, 204 und eines im Vergleich mit diesem positiven Potential stärkeren positiven elektrischen Potentials an den Gate-Bereich 206 sowie eines negativen elektrischen Potentials an den n⁺-dotierten Bereich 209 elektrische Ladungsträger, nämlich Elektronen, von dem n⁺-dotierten Bereich 209 über das p-dotierte Silizium-Substrat 201 und den Kanal-Bereich 208 durch die Gate-isolierende Schicht bis möglicherweise in den Gate-Bereich 206 hinein injiziert werden.

Allerdings ist die in Fig.2 gezeigte Test-Anordnung nur für das Testen der Funktionsfähigkeit eines unter Verwendung einer halbleitertechnologischen Prozessierung ausgebildeten Feldeffekttransistors 202, insbesondere zum Testen der Funktionsfähigkeit der Gate-isolierenden Schicht des Feldeffekttransistors, geeignet. Es ist ferner anzumerken, dass die Test-Anordnung 200 zu einem sehr großen Flächenverbrauch auf einem Silizium-Substrat 201 führt.
[1] offenbart eine Flash-Speicherarray-Struktur und ein Verfahren zum Herstellen einer Flash-Speicherarray-Struktur, welche Struktur eine vergrabene Silizidleitung aufweist.
[2] offenbart ein Verfahren zum Herstellen und Betreiben einer nichtflüchtigen Flash-Speicherzellen-Struktur mit einem in einem Graben gebildeten Hilfs-Gate.
[3] offenbart ein Verfahren zum Programmieren einer elektrisch programmierbaren Speicherzelle, bei der ein n-Well und ein p-Well in einem Substrat separat kontaktierbar sind.
[4] offenbart ein Verfahren zum Herstellen einer Flash-Speicherzelle, bei der in einem Substrat ein Bipolartransistor gebildet ist.

Der Erfindung liegt insbesondere das Problem zugrunde, eine Speicherzelle und eine Speicherzellen-Anordnung bereitzustellen, bei denen ein Programmieren mit verringertem Energiebedarf ermöglicht ist.

Das Problem wird durch eine Speicherzelle, durch eine Speicherzellen-Anordnung und durch ein Verfahren zum Herstellen einer Speicherzelle mit den Merkmalen gemäß den unabhängigen Patentansprüchen gelöst.

Die erfindungsgemäße Speicherzelle enthält ein Substrat, das Ladungsträger eines ersten Leitungstyps enthält. Ferner enthält die Speicherzelle einen ersten Source-/Drain-Bereich in einem ersten Oberflächenbereich des Substrats und einen zweiten Source-/Drain-Bereich in einem zweiten Oberflächenbereichs des Substrats. Ein Kanal-Bereich ist in einem Oberflächenbereich des Substrats zwischen dem ersten und dem zweiten Source-/Drain-Bereich gebildet. Ferner ist ein Ladungsspeicherbereich über dem Kanal-Bereich und ein Steuergate über dem Ladungsspeicherbereich gebildet, welches Steuergate von dem Ladungsspeicherbereich elektrisch isoliert ist. In dem Substrat ist eine Grabenstruktur gebildet, die Ladungsträger lieferndes Material mit Ladungsträgern eines zweiten Leitungstyps und einen Isolationsbereich zwischen dem Substrat und zumindest einem Teil des Ladungsträger liefernden Materials aufweist. Der erste Leitungstyp ist von dem zweiten Leitungstyp unterschiedlich, so dass zwischen dem Substrat und dem Ladungsträger liefernden Material der Grabenstruktur ein Dioden-Übergang, bei Verwendung eines Halbleitermaterials als Ladungsträger lieferndes Material je nach Dotierung ein pn-Übergang oder ein np-Übergang, bei Verwendung z.B. eines Metalls wie Wolfram eine Schottky-Diode, gebildet ist. Ferner ist die Speicherzelle derart eingerichtet, dass mittels Anlegens vorgebbarer elektrischer Potentiale an die Speicherzelle elektrische Ladungsträger aus dem Ladungsträger liefernden Material der Grabenstruktur in den Ladungsspeicherbereich einbringbar sind.

Die erfindungsgemäße Speicherzellen-Anordnung enthält eine Mehrzahl von in dem Substrat integrierten Speicherzellen mit den oben genannten Merkmalen.

Bei dem erfindungsgemäßen Verfahren zum Herstellen einer Speicherzelle wird ein erster Source-/Drain-Bereich in einem ersten Oberflächenbereichs eines Substrats, das Ladungsträger eines ersten Leitungstyps enthält, und ein zweiter Source-/Drain-Bereich in einem zweiten Oberflächenbereich des Substrats gebildet. Ferner wird ein Kanal-Bereich in dem Oberflächenbereich des Substrats zwischen dem ersten und dem zweiten Source-/Drain-Bereich gebildet. Ein Ladungsspeicherbereich wird über dem Kanal-Bereich gebildet. Eine Steuergate wird über dem Ladungsspeicherbereich gebildet, welches von dem Ladungsspeicherbereich elektrisch isoliert wird. Darüber hinaus wird eine in dem Substrat angeordnete Grabenstruktur gebildet, die Ladungsträger lieferndes Material mit Ladungsträgern eines zweiten Leitungstyps und einem Isolationsbereich zwischen dem Substrat und zumindest einem Teil des Ladungsträger liefernden Materials aufweist. Der erste Leitungstyp wird von dem zweiten Leitungstyp unterschiedlich eingestellt, so dass zwischen dem Substrat und dem Ladungsträger liefernden Material der Grabenstruktur ein Dioden-Übergang gebildet wird. Die Speicherzelle wird ferner derart eingerichtet, dass mittels Anlegens vorgebbarer elektrischer Potentiale an die Speicherzelle elektrische Ladungsträger aus dem Ladungsträger liefernden Material der Grabenstruktur in den Ladungsspeicherbereich einbringbar sind.

Eine Grundidee der Erfindung ist darin zu sehen, dass bei einer integrierten Speicherzelle ein Graben mit erhöhter Ladungsträger-Konzentration als Lieferant für Ladungsträger zum Injizieren in einen Ladungsspeicherbereich der Speicherzelle geschaffen ist. Das Injizieren kann mittels Anlegens vorgebbarer elektrischer Potentiale an die Anschlüsse der Speicherzelle, insbesondere an die Grabenstruktur und/oder die Substrat-Schicht und das Steuergate, erfolgen. Ferner ist die erfindungsgemäße Speicherzelle sehr platzsparend implementierbar, da die üblicherweise in Speicherzellen auftretende STI-Isolation ("Shallow Trench Isolation") zum Entkoppeln benachbarter Speicherzellen einer Speicherzellen-Anordnung anschaulich ausgehöhlt werden kann und mit einem elektrisch leitfähigen Material (beispielsweise in n⁺-dotierten Polysilizium) gefüllt werden können. Die dadurch gebildete Grabenstruktur kann dann einerseits als Isolation zu benachbarten Bauelementen in dem Substrat und andererseits als ausreichend tief in einem Substrat integrierter Ladungsträger-Emitter verwendet werden, ohne dass der Platzbedarf dadurch erhöht wird. Angesichts des Bedarfs an hochdichten und sicher programmierbaren Speicherzellen stellt der geringe Platzbedarf der erfindungsgemäßen Speicherzelle einen wichtigen Vorteil dar. Die erfindungsgemäße Speicherzelle ist zum Injizieren heißer elektrischer Ladungsträger (Elektronen oder Löcher) von der Grabenstruktur über ein Substrat bis hin in die Ladurigsspeicherschicht eingerichtet. Anschaulich ist der Emitter zum Emittieren elektrischer Ladungsträger in einen Graben mit zumindest teilweiser Seitenwandisolation eingebettet.

Die erfindungsgemäße Speicherzelle kann als n-Kanal-Speicherzelle oder als p-Kanal-Speicherzelle realisiert sein.

Das Mitverwenden einer mit elektrisch leitfähigem Material gefüllten STI-Isolation als Zuführstruktur von Ladungsträgern zum Injizieren in einen Ladungsspeicherbereich ist eine besonders platzsparende Lösung.

Es ist anzumerken, dass der Leitungstyp (im Falle eines Halbleiter-Materials p-leitend oder n-leitend) der Ladungsträger (Dotieratome im Falle eines Halbleiter-Materials) in dem Substrat einerseits und in dem Ladungsträger liefernden Material der Grabenstruktur andererseits unterschiedlich ist, d.h. komplementär zueinander (beispielsweise p-leitendes Substrat und n-leitendes oder metallisches Ladungsträger lieferndes Material der Grabenstruktur oder n-leitendes Substrat und p-leitendes Ladungsträger lieferndes Material der Grabenstruktur). Folglich ist in einem Übergangsbereich bzw. Grenzbereich zwischen dem Substrat und dem Ladungsträger liefernden Material der Grabenstruktur ein Dioden-Übergang (pn-Übergang oder Schottky-Übergang) gebildet.

Mittels Anlegens geeignet gewählter elektrischer Potentiale an die Grabenstruktur bzw. das Steuergate ist es dann ermöglicht, die Diode in dem Grenzbereich in Durchlassrichtung zu betreiben, und somit elektrische Ladungsträger des Ladungsträger liefernden Materials in das Substrat hin zu dem Ladungsspeicherbereich zu injizierenwelche Ladungsträger beim Durchlaufen des Substrats aufgrund einer an das Steuergate angelegten elektrischen Spannung beschleunigt werden und somit in den Ladungsspeicherbereich dauerhaft einbringbar sind.

Die erfindungsgemäße Speicherzelle weist insbesondere den Vorteil auf, dass eine gleichmäßige Ladungsträgerinjektion in eine Ladungsspeicherschicht ermöglicht ist, was zu einer geringeren Degradation der Ladungsspeicherschicht führt.

Ferner ist ein lokales Injizieren unmittelbar in einem Nachbarbereich einer Speicherzelle ermöglicht, da mittels Anlegens geeigneter Potentiale an die Anschlüsse der Speicherzelle die Strompfade der Ladungsträger in dem Substrat vorgebbar sind. Das lokale Injizieren von Ladungsträgern bei einer Speicherzelle führt zu einem geringen Energiebedarf und der Möglichkeit, einzelne Zellen zu adressieren. Ferner ist der Emitter der elektrischen Ladungsträger in einem Graben eingebettet, was zu einem geringen Platzbedarf führt.

Bevorzugte Weiterbildungen der Erfindung ergeben sich aus den abhängigen Ansprüchen.

Die Grabenstruktur erstreckt sich vorzugsweise tiefer in das Substrat hinein als der erste und der zweite Source-/Drain-Bereich. Dadurch ist sichergestellt, dass elektrische Ladungsträger sehr homogen in die Ladungsspeicherschicht eingebracht werden können. Dadurch ist die Lebensdauer der Speicherzelle, insbesondere der Ladungsspeicherschicht, erhöht.

Ferner ist anzumerken, dass für den Fall, dass die Komponenten der erfindungsgemäßen Speicherzelle in einer in dem Substrat ausgebildeten Wanne eines vorgegebenen Leitungstyps integriert sind, die vertikale Tiefe der Grabenstruktur nicht die Tiefe des Wannenbereichs in dem Substrat überschreiten darf.

Die Grabenstruktur erstreckt sich vorzugsweise im Wesentlichen in vertikaler Richtung zu der Oberfläche des Substrats.

Bei der Speicherzelle kann die Grabenstruktur seitlich von zumindest einem der Source-/Drain-Bereiche und außerhalb des Kanal-Bereichs gebildet sein.

Die erfindungsgemäße Speicherzelle kann zwei (oder mehr) Grabenstrukturen in dem Substrat aufweisen, von denen eine seitlich des ersten Source-/Drain-Bereichs und außerhalb des Kanal-Bereichs angeordnet ist und die andere seitlich des zweiten Source-/Drain-Bereichs und außerhalb des Kanal-Bereichs angeordnet ist. Diese Konfiguration ist symmetrisch, so dass ein besonders homogenes. Injizieren von elektrischen Ladungsträgern in die Ladungsspeicherschicht ermöglicht ist. Ferner kann mittels zweier symmetrisch angeordneter Grabenstrukturen mittels ihrer Isolationsbereiche die Speicherzelle nach beiden Seiten hin von möglicherweise in benachbarten Bereichen des Substrats angeordneten Komponenten elektrisch entkoppelt werden, um eine unerwünschte elektrische Wechselwirkung zwischen solchen Komponenten und der Speicherzelle zu vermeiden. Allerdings sind auch andere Integrationen denkbar (z.B. NAND-Architekturen)

Die Grabenstruktur kann einen elektrisch isolierenden Mantelbereich an zumindest einem Teil der Seitenwand des Grabens und einen in den Graben eingefüllten elektrisch leitfähigen Kernbereich aufweisen derart, dass elektrische Ladungsträger aus der Grabenstruktur nur von solchen Bereichen in das Substrat austreten können, in welchen der Kernbereich von einer Ummantelung mit dem Mantelbereich frei ist, oder von solchen Bereichen, in welchen der Mantelbereich eine ausreichend geringe Dicke aufweist, um einen Tunnelstrom von Ladungsträgern aus dem Ladungsträger liefernden Material durch den Mantelbereich in das Substrat hinein zu ermöglichen.

Die Grabenstruktur kann zum Beispiel hergestellt werden, indem zunächst ein Graben in dem Substrat ausgebildet wird. Danach wird z.B. in einem Abscheideverfahren oder durch thermische Oxidation eine Isolationsschicht an der Seitenwand des Grabens und dessen Boden ausgebildet. Danach wird beispielsweise mit einem unisotropen Ätzschritt (z.B. durch reactive ion etching (RIE)) die Isolationsschicht zumindest teilweise vom Boden des Grabens und/oder von dessen Seitenwand im unteren Bereich entfernt. Nachfolgend wird der Graben mit dem Ladungsträger emittierenden Material gefüllt, wodurch ein Dioden-Übergang in dem Kontaktbereich gebildet ist. Dann können ausgehend von dem Bodenbereich des Grabens Ladungsträger von der Grabenstruktur in das Substrat eingebracht werden. Es wird beispielsweise in situ dotiertes Polysilizium-Material oder ein Metall in den in dem Graben eingebrachten Hohlraum eingefüllt, wodurch die Grabenstruktur gebildet wird.

Vorzugsweise grenzt ein Teilbereich des Ladungsträger liefernden Materials der Grabenstruktur direkt an Material des Substrats an. Es ist jedoch auch möglich, dass Isolationsmaterial einer ausreichend geringen Dicke (typischerweise kleiner 2nm) zwischen dem Substrat und dem Ladungsträger liefernden Material der Grabenstruktur verbleibt bzw. ausgebildet oder eingebracht wird. In diesem Falle können bei Anlegen geeigneter elektrischer Potentiale an die Grabenstruktur und das Steuergate.elektrische Ladungsträger durch die dünne elektrisch isolierende Schicht hindurchtunneln.

Der Ladungsspeicherbereich kann ein Floating-Gate sein. Insbesondere kann ein als Floating-Gate ausgebildeter Ladungsspeicherbereich Polysilizium aufweisen. Bei dieser Ausgestaltung ist zwischen dem Substrat und dem Floating-Gate eine Gate-isolierende Schicht zum elektrischen Isolieren des Kanal-Bereichs von dem Floating-Gate vorzusehen.

Alternativ kann der Ladungsspeicherbereich ein elektrisch isolierender Ladungsspeicherbereich sein. Als elektrisch isolierender Ladungsspeicherbereich kann eine Siliziumoxid-Siliziumnitrid-Siliziumoxid-Schichtenfolge (ONO-Schichtenfolge)verwendet werden. Alternativ kann die Siliziumnitrid-Schicht durch ein anderes Material ersetzt werden wie z.B. Aluminiumoxid (Al₂O₃), Yttriumoxid (Y₂O₃), Lanthanoxid (LaO₂), Hafniumoxid (HfO₂) und/oder Zirkoniumoxid (ZrO₂). Insbesondere ist eine Siliziumoxid-Aluminiumoxid-Siliziumoxid-Schichtenfolge, eine Siliziumoxid-Yttriumoxid-Siliziumoxid-Schichtenfolge, eine Siliziumoxid-Lanthanoxid-Siliziumoxid-Schichtenfolge, eine Siliziumoxid-Hafniumoxid-Siliziumoxid-Schichtenfolge, eine Siliziumoxid-Zirkoniumoxid-Schichtenfolge und/oder eine andere Schichtenfolge möglich, die eine dauerhafte Ladungsspeicherung ermöglicht. Ein solcher elektrisch isolierender Ladungsspeicherbereich wird auch als Charge Trapping Layer bezeichnet. Beispielsweise werden bei Verwendung einer ONO-Schichtenfolge elektrische Ladungsträger in die Siliziumnitrid-Schicht der ONO-Schichtenfolge injiziert und dort dauerhaft insbesondere in Fehlstellen gespeichert.

Das Substrat kann einen die Ladungsträger, insbesondere Dotieratome, des ersten Leitungstyps aufweisenden Wannenbereich aufweisen und kann einen Ladungsträger, insbesondere Dotieratome, des zweiten Leitungstyps aufweisenden Bereich aufweisen, wobei in dem Wannenbereich die Komponenten der Speicherzelle gebildet sind. Mit anderen Worten muss als Substrat der erfindungsgemäßen Speicherzelle nicht notwendigerweise ein homogenes Substrat verwendet werden. Es ist beispielsweise möglich, in einem p-dotierten Substrat einen n-dotierten Wannenbereich auszubilden und in diesem die erfindungsgemäße Speicherzelle auszubilden. Auch ist eine Mehrfachwannenstruktur aus anschaulich ineinander verschachtelten Wannenbereichen unterschiedlicher Leitungstypen möglich (beispielsweise eine n-Wanne in einem p-Substrat und eine p-Wanne in der n-Wanne).

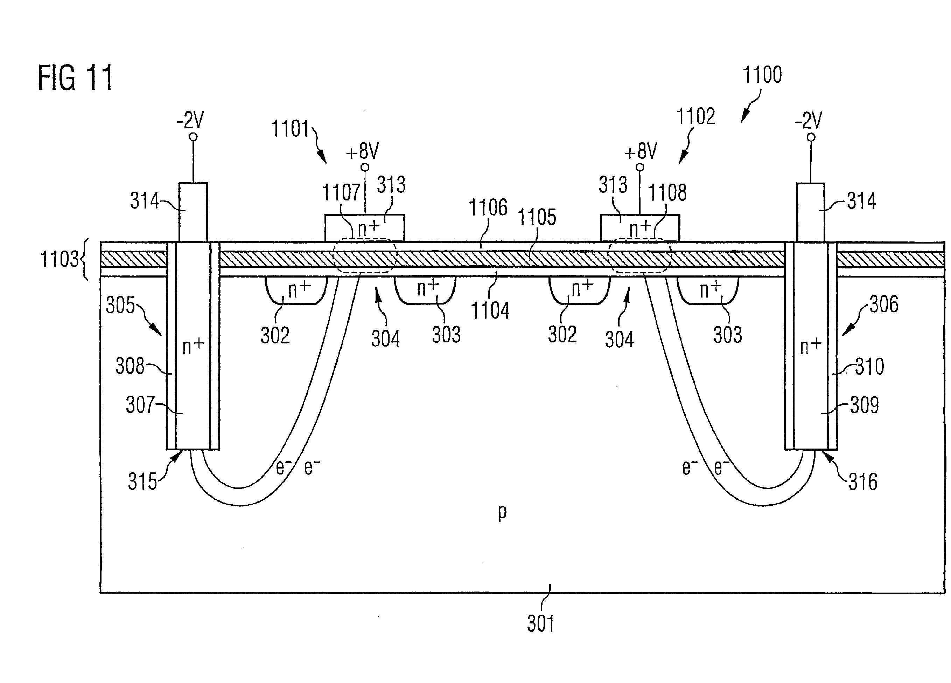

Die Speicherzelle kann eine Mehrzahl von räumlich getrennten und elektrisch separat ansteuerbaren Steuergates aufweisen, derart, dass mittels Anlegens vorgebbarer elektrischer Potentiale an mindestens ein ausgewähltes der Steuergates elektrische Ladungsträger von der Grabenstruktur in einen an das mindestens eine ausgewählte Steuergate benachbarten Bereich des Ladungsspeicherbereichs einbringbar sind. Eine solche Ausgestaltung ist beispielsweise in Fig.11 gezeigt.

Gemäß einem Aspekt dieser Ausgestaltung können anschaulich mehrere Feldeffekttransistoren in der erfindungsgemäßen Speicherzelle nebeneinander in dem Substrat ausgebildet sein. Jedem der Transistoren ist ein eigenes Steuergate zugeordnet. Ferner kann für alle Feldeffekttransistoren eine gemeinsame Ladungsspeicherschicht vorgesehen sein, alternativ kann jeder Transistor eine eigene Ladungsspeicherschicht aufweisen.

Gemäß einem anderen Aspekt der betrachteten Ausgestaltung kann eine Speicherzelle der Erfindung nur einen Feldeffekttransistor aufweisen, in dessen Ladungsspeicherbereich in zwei räumlich getrennte Abschnitte jeweils Ladungsträger eingebracht werden können, wobei jedem der Abschnitte ein separat ansteuerbares Steuergate zugeordnet sein kann. In einem solchen Fall kann in jedem der Abschnitte eine Information von einem Bit gespeichert sein, so dass in einem Feldeffekttransistor eine Mehrzahl von Bits gespeichert sein kann.

Somit kann die erfindungsgemäße Speicherzelle derart eingerichtet werden, dass mehrere Bits Information in der Speicherzelle speicherbar sind. Anschaulich können bei Verwendung von n Steuergates in der Ladungsspeicherschicht n Bit Information gespeichert werden.

Eine solche Mehrfach-Bit-Speicherzelle kann zum Beispiel wie folgt beschrieben programmiert werden. Zunächst kann beispielsweise mittels des erfindungsgemäßen Injizierens heißer Ladungsträger alle Information aus der Ladungsspeicherschicht bzw. den Ladungsspeicherschichten des mindestens einen Feldeffekttransistors gelöscht werden, was anschaulich einem Rücksetzen der Speicherinhalte entspricht. Dies kann zum Beispiel dadurch erfolgen, dass in die gesamte Ladungsspeicherschicht heiße Elektronen eingebracht werden können. Nachfolgend kann jeder, einem jeweiligen Steuergate zugeordneter Bereich der Ladungsspeicherschicht beispielsweise mittels Fowler-Nordheim-Tunnelns, d.h. mit besonders guter räumlicher Auflösung und somit auf einen ganz bestimmten ausgewählten Bereich der Ladungsspeicherschicht beschränkt, separat programmiert werden. Somit ist die Speicherzelle der Erfindung als hochdichtes Speichermedium eingerichtet.

Bei der Speicherzelle können die Ladungsträger des ersten Leitungstyps und/oder die Ladungsträger des zweiten Leitungtyps Dotieratome sein. Diese Ausgestaltung betrifft insbesondere Realisierungen der Speicherzelle unter Verwendung eines Halbleitermaterials für das Substrat und/oder das Ladungsträger liefernde Material.

Im Weiteren wird die erfindungsgemäße Speicherzellen-Anordnung, die erfindungsgemäße Speicherzellen aufweist, näher beschrieben. Ausgestaltungen der Speicherzelle gelten auch für die Speicherzellen aufweisende Speicherzellen-Anordnung.

Die Speicherzellen-Anordnung kann derart ausgebildet sein, dass mittels der elektrisch isolierenden Mantelbereiche unterschiedliche Speicherzellen voneinander elektrisch entkoppelt sind. Diese Ausgestaltung entspricht der Realisierung der Grabenstruktur unter Verwendung einer anschaulich ausgehöhlten STI-Struktur, welche abgesehen von ihrer Isolations-Funktion zusätzlich die Funktion einer Ladungsträger-Zuführstruktur zum Injizieren von elektrischen Ladungsträgern in das Substrat erfüllt.

Im Weiteren wird das erfindungsgemäße Verfahren zum Herstellen der erfindungsgemäßen Speicherzelle näher beschrieben. Ausgestaltungen der Speicherzelle gelten auch für das Verfahren zum Herstellen der Speicherzelle und umgekehrt.

Es ist möglich, zuerst die Grabenstruktur herzustellen und danach die Source/Drain-Bereiche sowie die Gatestruktur (d.h. Ladungsspeicherbereich und Steuergate) herzustellen.

Die Grabenstruktur kann gebildet werden, indem zumindest ein Graben in dem Substrat gebildet wird, ein elektrisch isolierender Mantelbereich zumindest an zumindest einem Teil der Oberfläche des mindestens einen Grabens gebildet wird und ein elektrisch leitfähiger Kernbereich in dem mindestens ein Graben gebildet wird. Gemäß dieser Ausgestaltung kann beispielsweise zunächst ein Graben in das Substrat eingebracht werden und nachfolgend ein elektrisch isolierender Mantelbereich ausgebildet werden. Dies kann beispielsweise dadurch erfolgen, dass mittels thermischen Oxidierens der Seitenwand des Grabens eine elektrisch isolierende Schicht generiert wird. Nachfolgend kann in die erhaltene Anordnung Ladungsträger lieferndes Material, z.B. dotiertes Polysilizium, eingebracht werden, wodurch die Grabenstruktur gebildet wird.

Alternativ kann der Graben mit elektrisch isolierendem Material aufgefüllt werden und dieses unter Verwendung eines Lithographie- und eines Ätzverfahrens teilweise aus dem Graben entfernt werden. Bei dem Verfahren kann die Grabenstruktur somit gebildet werden, indem zumindest ein Graben in dem Substrat gebildet wird und der Graben mit elektrisch isolierendem Material gefüllt wird. Ein Teil des elektrisch isolierenden Materials wird aus dem Graben entfernt, wodurch der elektrisch isolierende Mantelbereich gebildet wird. Ein elektrisch leitfähiger Kernbereich wird in dem mindestens einen Graben gebildet.

Ausführungsbeispiele der Erfindung sind in den Figuren dargestellt und werden im Weiteren näher erläutert.

Es zeigen:
- Figur 1: eine Speicherzelle gemäß dem Stand der Technik,
- Figur 2: eine Test-Anordnung gemäß dem Stand der Technik,
- Figur 3: eine Speicherzelle gemäß einem ersten Ausführungsbeispiel der Erfindung,
- Figur 4: eine Speicherzelle gemäß einem zweiten Ausführungsbeispiel der Erfindung,
- Figur 5: eine Speicherzelle gemäß einem dritten Ausführungsbeispiel der Erfindung,
- Figur 6: eine Speicherzelle gemäß einem vierten Ausführungsbeispiel der Erfindung,
- Figur 7: eine Speicherzelle gemäß einem fünften Ausführungsbeispiel der Erfindung,
- Figur 8: eine Speicherzelle gemäß-einem sechsten Ausführungsbeispiel der Erfindung,
- Figur 9: die in Figur 3 gezeigte Speicherzelle in einem Betriebszustand zum Einbringen von Elektronen in den Ladungsspeicherbereich,
- Figur 10: die in Figur 4 gezeigte Speicherzelle in einem Betriebszustand zum Einbringen von Löchern in die Ladungsspeicherschicht,
- Figur 11: eine Speicherzelle gemäß einem siebten Ausführungsbeispiel der Erfindung,
- Figur 12: eine Layout-Ansicht einer Speicherzellen-Anordnung gemäß einem Ausführungsbeispiel der Erfindung,
- Figur 13: eine Speicherzelle gemäß einem achten Ausführungsbeispiel der Erfindung,
- Figur 14: eine Layout-Ansicht einer Speicherzellen-Anordnung gemäß einem anderen Ausführungsbeispiel der Erfindung.

Gleiche oder ähnliche Komponenten in unterschiedlichen Figuren sind mit gleichen Bezugsziffern versehen.

Die Darstellungen in den Figuren sind schematisch und nicht maßstäblich.

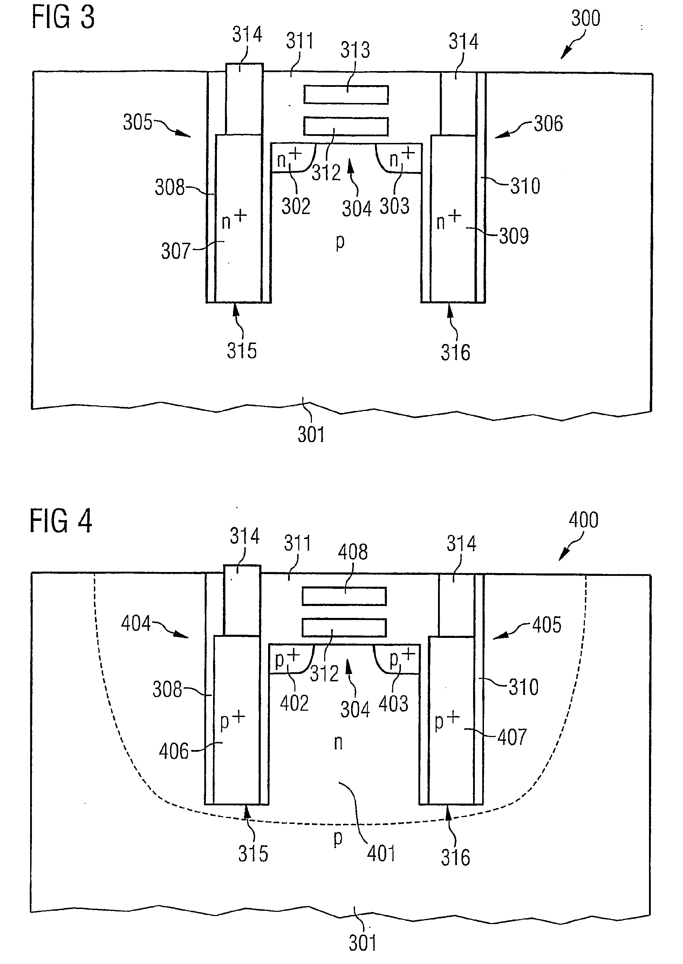

Im Weiteren wird bezugnehmend auf **Fig.3** eine Speicherzelle 300 gemäß einem ersten Ausführungsbeispiel der Erfindung beschrieben.

Die Speicherzelle 300 ist auf und in einem p-dotierten Silizium-Substrat 301 ausgebildet. In einem ersten Oberflächenbereich des p-dotierten Silizium-Substrats 301 ist ein erster Source-/Drain-Bereich 302 als n⁺-dotierter Bereich gebildet. In einem zweiten Oberflächenbereich des p-dotierten Silizium-Substrats 301 ist ein zweiter Source-/Drain-Bereich 303 als n⁺-dotierter Bereich gebildet. In dem Oberflächenbereich zwischen dem ersten und zweiten Source/Drain-Bereich 302, 303 ist ein Kanal-Bereich 304 der Floating-Gate-Anordnung 300 gebildet. In dem Substrat 301, seitlich von dem ersten Source-/Drain-Bereich 302 und außerhalb des Kanal-Bereichs 304 ist eine erste Grabenstruktur 305 gebildet, welche einen ersten n⁺-dotierten Polysilizium-Kern 307 und einen teilweise darum herum ausgebildeten ersten Siliziumoxid-Mantel 308 enthält. In dem Substrat 301, seitlich von dem zweiten Source-/Drain-Bereich 303 und außerhalb des Kanal-Bereichs 304 ist eine zweite Grabenstruktur 306 gebildet. Diese enthält einen zweiten n⁺-dotierten Polysilizium-Kern 309 und zweiten Siliziumoxid-Mantel 310, welcher den Kern 309 umgibt. Mittels eines elektrischen Isolationsbereichs 311 aus Siliziumoxid-Material ist der Kanal-Bereich 304 von einem Floating-Gate 312 aus Polysilizium-Material elektrisch getrennt. Ferner ist mittels des elektrischen Isolationsbereichs 311 das über dem Floating-Gate 312 ausgebildete Steuergate 313 von dem Floating-Gate 312 elektrisch getrennt. Kontaktierungselemente 314 sind als Vias realisiert und ermöglichen es, den Grabenstrukturen 305, 306 ein vorgebbares elektrisches Potential bereitzustellen. Zwischen dem ersten n⁺-dotierten Polysilizium-Kern 307 und dem p-dotierten Substrat 301 ist ein erster pn-Übergang 315, das heißt ein erster Dioden-Übergang geschaffen. Ferner ist zwischen dem zweiten n⁺-dotierten Polysilizium-Kern 309 und dem p-dotierten Silizium-Substrat 301 ein zweiter pn-Übergang 316 realisiert.

Die Grabenstrukturen 305, 306 weisen aufgrund der Siliziumoxid-Mäntel 308, 310 eine elektrische Isolation der in Fig.3 gezeigten Speicherzelle von möglicherweise in benachbarten Teilbereichen des Substrats 301 ausgebildeten anderen Komponenten, beispielsweise anderer Speicherzellen, auf.
In Fig.3 bis Fig.8 sind Realisierungsmöglichkeiten basierend auf einem p-Substrat beschrieben. Die gleichen Realisierungsvarianten sind auch auf einem n-Substrat möglich (umgekehrte Dotierungen für Substrat, Wannen, Trench-Füllung, Source/Drain).Anstelle einer n⁺-Fuellung des Trenches kann auch eine metallische Füllung, z.B. aus Wolfram-Material, verwendet werden.

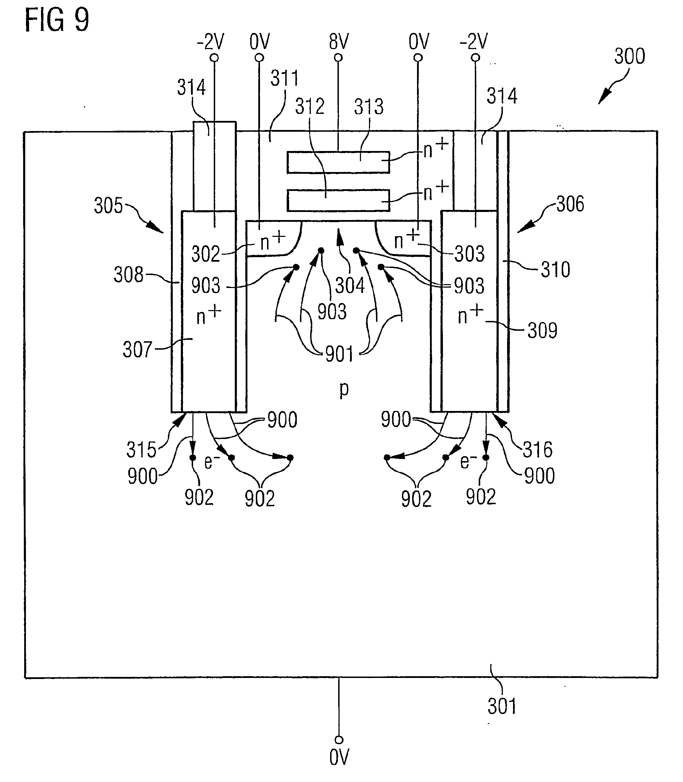

Im Weiteren wird bezugnehmend auf Fig.3, Fig.9 beschrieben, wie elektrische Ladungsträger in das n⁺-dotierte Floating-Gate 312 aus Polysilizium als Ladungsspeicherbereich eingebracht werden können, dass heißt wie eine Information in die Speicherzelle 300 programmiert werden kann.

Zum Einschreiben einer Speicherinformation in die nichtflüchtige Speicherzelle 300, das heißt zum dauerhaften Einbringen von Elektronen in das Floating-Gate 312, werden, wie in Fig.9 gezeigt, die ersten und zweiten n⁺-dotierten Polysilizium-Kerne 307, 309 auf ein negatives elektrisches Potential (z.B. von -2Volt) gebracht. Die Source-/Drain-Bereiche 302, 303 werden auf dem Potential des Substrates gehalten. An das Steuergate 313 (das zum Beispiel n⁺ dotiert sein kann, aber nicht muss) wird ein positives elektrisches Potential von z.B. +8Volt angelegt. Die Dotierung der Gate-Bereiche ist von keiner sonderlichen Bedeutung, so dass keine Festlegung auf einen bestimmten Dotierungstyp gegeben ist. Das p-dotierte Silizium-Substrat 301 kann auf dem elektrischen Massepotential gehalten werden. Bei den beschriebenen Potentialverhältnissen können Elektronen aus dem ersten n⁺-dotierten Polysilizium-Kern 307 der Grabenstruktur 305 bzw. aus dem zweiten n⁺-dotierten Polysilizium-Kern 309 der zweiten Grabenstruktur 306 an den pn-Übergängen 315, 316 zu dem p-dotierten Substrat 301 in das Substrat 301 austreten. Es ist anzumerken, dass in solchen Bereichen, in welchen das p-dotierte Substrat 301 von den n⁺-dotierten Polysilizium-Kernen 307, 308 mittels der Siliziumoxid-Mantelbereiche 308, 310 getrennt ist, ein Austreten von elektrischen Ladungsträgern vermieden ist, es sei denn, die Dicke der elektrisch isolierenden Mantelbereiche 308, 310 ist derart dünn, dass ein elektrischer Tunnelstrom ermöglicht ist. Anschaulich werden erste Elektronen 902 aufgrund der in Durchlassrichtung vorgespannten Dioden 315, 316 in das Silizium-Substrat 201 injiziert, wie mittels erster Strompfade 900 angedeutet ist. Aufgrund der starken positiven Vorspannung des Steuergates 313 erfolgt eine Beschleunigung der injizierten negativ geladenen ersten Elektronen 902 hin zu dem Kanal-Bereich 304 des p-dotierten Substrats 301, was mittels zweiter Strompfade 901 veranschaulicht ist. Die beschleunigten, "heißen" zweiten Elektronen 903 können dann durch die Gate-isolierende Schicht des elektrischen Isolationsbereichs 311, das heißt zwischen Kanal-Bereich 304 und Floating-Gate 312 gelangen und in das Floating-Gate 312 injiziert werden und verbleiben dort dauerhaft.

Die Floating-Gate-Speicherzelle 300 weist in einem ersten Betriebszustand, in welchem das Floating-Gate 312 idealerweise von elektrischen Ladungsträgern frei ist, eine andere Schwellenspannung auf als in einem Szenario, in dem elektrische Ladungsträger in dem Floating-Gate 312 injiziert sind. Anschaulich wirken in dem Floating-Gate 312 enthaltene Elektronen ähnlich wie eine an das Steuergate 313 angelegte externe elektrische Spannung, so dass die Stärke eines Stromflusses zwischen den Source-/Drain-Bereichen 302, 303 bei einer zwischen diesen angelegten festen Spannung davon abhängig ist, ob in dem Floating-Gate 312 elektrische Ladungsträger injiziert sind oder nicht. In der Stärke eines solchen Lesestroms ist Information mit einem logischen Wert "1" (z.B. Elektronen in Floating-Gate 312 vorhanden) oder einem logischen Wert "0" (z.B. Elektronen in Floating-Gate 312 nicht vorhanden) enthalten.

Im Weiteren wird bezugnehmend auf **Fig.4** eine Speicherzelle 400 gemäß einem zweiten Ausführungsbeispiel der Erfindung beschrieben.

Die Speicherzelle 400 unterscheidet sich von der Speicherzelle 300 im Wesentlichen dadurch, dass die Leitungstypen der dotierten Bereiche bei der Speicherzelle 400 anders ausgebildet sind als bei der Speicherzelle 300.

Die Speicherzelle 400 weist ebenfalls ein p-dotiertes Silizium-Substrat 301 auf. Allerdings ist in dem p-dotierten Silizium-Substrat 301 ein n-dotierter Wannenbereich 401 gebildet, der auch als Hochvolt-n-Wannenbereich bezeichnet werden kann. Als erster und zweiter Source-/Drain-Bereich 402, 403 sind p⁺-dotierte Bereiche im ersten und zweiten Oberflächenbereichen des n-Wannenbereichs 401 gebildet. Ferner sind erste und zweite Grabenstrukturen 404, 405 vorgesehen, welche sich von den ersten und zweiten Grabenstrukturen 305, 306 aus Fig.3 dahingehend unterscheiden, dass erste und zweite p⁺-dotierte Polysilizium-Kerne 406, 407 der Grabenstrukturen 404, 405 aus p⁺-dotiertem Polysilizium, statt aus nu-dotiertem Polysilizium wie in Fig.3, hergestellt sind. Das in Fig.4 vorgesehene n⁺-dotierte Steuergate kann alternativ auch als p⁺-dotiertes Steuergate realisiert werden. Auch bei der Speicherzelle 400 bildet der Übergang zwischen dem ersten p⁺-dotierten Polysilizium-Kern 406 und dem n-Wannenbereich 401 eine erste Diode 315, und der Übergang zwischen dem zweiten n⁺-dotierten Polysilizium-Kern 407 und dem n-Wannenbereich 401 bildet eine zweite Diode 316.

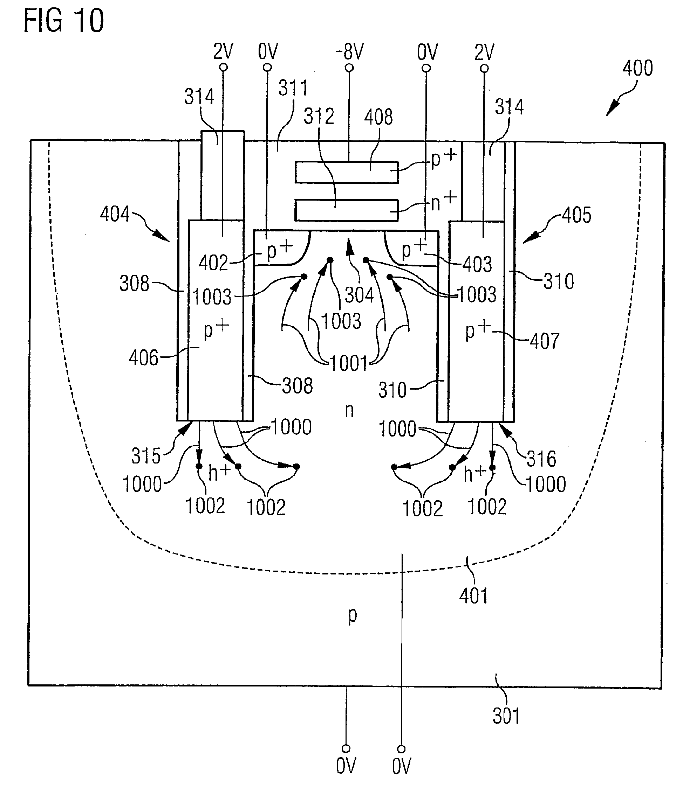

Im Weiteren wird bezugnehmend auf Fig.4, Fig.10 die Funktionalität der Speicherzelle 400 beschrieben.

In Fig.10 ist gezeigt, welche Potentiale an die Anschlüsse der Speicherzelle 400 anzulegen sind, um heiße Löcher (in den Figuren mit h⁺ bezeichnet) in das Floating-Gate 312 zu injizieren. Hierfür werden die ersten und zweiten p⁺-dotierten Polysilizium-Kerne 406, 407 auf ein Potential von z.B. +2Volt gebracht. Die Source-/Drain-Anschlüsse 402, 403 werden auf dem Potential der n-Wanne 401 gehalten. Die Anschlüsse des p-dotierten Substrats 301 und des n-Wannenbereichs 401 werden vorzugsweise auf dem elektrischen Massenpotential gehalten. Das Steuergate 408 wird dagegen auf ein negatives Potential von z.B. -8Volt gebracht. Es sei darauf hingewiesen, dass die n-Wanne auf ein positives Potential gelegt werden kann. Dadurch sind alle anderen angelegten Potentiale in Bezug zu diesem positiven n-WannenPotential zu sehen. Die Dioden 315, 316 werden gemäß Fig.10 in Durchlassrichtung betrieben. Aufgrund der in Durchlassrichtung betriebenen Dioden, 315, 316 werden erste Löcher 1002 h⁺ in den n-Wannenbereich 401 injiziert, was mittels erster Strompfade 1000 veranschaulicht ist. Aufgrund des stark negativen Potentials an dem Steuergate 408 werden die positiv geladenen ersten 1002 Löcher hin zu dem Kanal-Bereich 304 beschleunigt, wodurch die ersten Löcher 1002 in "heiße" zweite Löcher 1003 umgewandelt werden. Die zweiten Löcher 1003 können aufgrund ihrer ausreichend hohen kinetischen Energie bis in den Floating-Gate-Bereich 312 gelangen, in welchen sie injiziert werden. Wiederum kann mittels einer Verschiebung der Schwellenspannung der transistorähnlichen Anordnung 400 ermittelt werden, ob in dem Floating-Gate 312 der Speicherzelle 400 elektrische Ladungsträger (nämlich Löcher) injiziert sind oder nicht. Ein Lesestrom mit einem hohen bzw. niedrigen Wert bei konstanter Spannung zwischen den Source-/Drain-Bereichen 402, 403 kann einer Information mit dem logischen Wert "1" bzw. "0" zugeordnet werden.

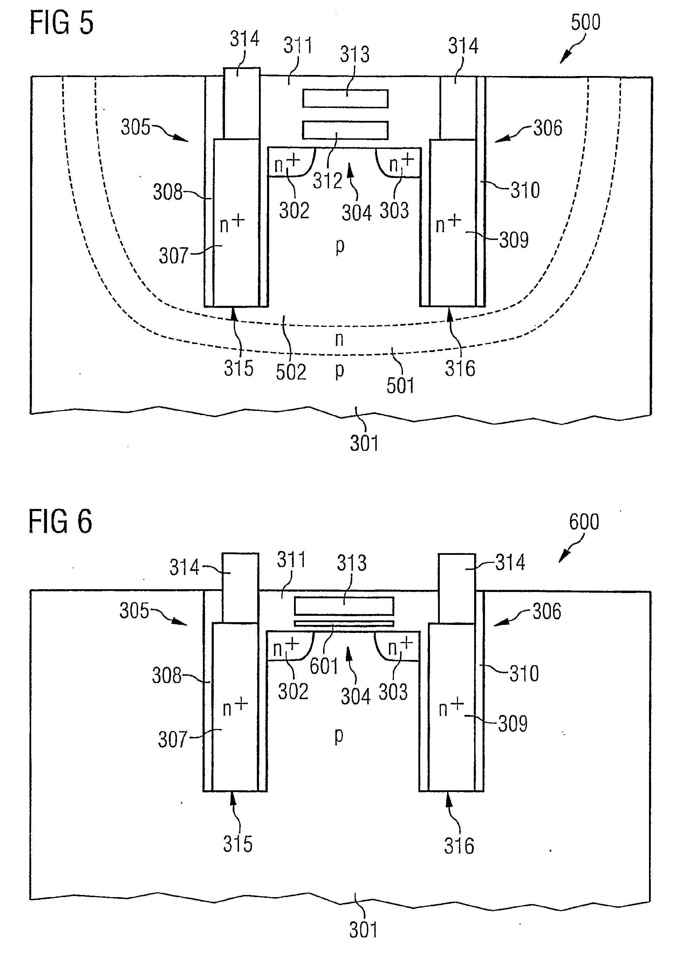

Im Weiteren-wird bezugnehmend auf **Fig.5** eine Speicherzelle 500 gemäß einem dritten Ausführungsbeispiel der Erfindung beschrieben.

Die in Fig.5 gezeigte Speicherzelle 500 unterscheidet sich von der in Fig.3 gezeigten Speicherzelle 300 im Wesentlichen dadurch, dass die Speicherzelle nicht direkt in dem p-dotierten Substrat 301 ausgebildet ist, sondern in einem p-dotierten kleinen Wannenbereich 502, welcher wiederum innerhalb eines n-dotierten großen Wannenbereichs 501 gebildet ist. Mit anderen Worten ist es nicht erforderlich, dass die erfindungsgemäße Speicherzelle direkt in ein. Substrat integriert ist, vielmehr kann sie auch in einem in dem Substrat eingebrachten Wannenbereich ausgebildet sein. Insbesondere kann in einer solchen Wannenkonstruktion ein negatives Potential an die (innere) p-Wanne angelegt werden. Dies bedeutet, 1 dass die an andere Bereiche angelegten Spannungen immer in Bezug zu diesem negativen Wannenpotential zu sehen sind.

Im Weiteren wird bezugnehmend auf **Fig.6** eine Speicherzelle 600 gemäß einem vierten Ausführungsbeispiel der Erfindung beschrieben.

Die in Fig.6 gezeigte Speicherzelle 600 unterscheidet sich von der in Fig.3 gezeigten Speicherzelle 300 im Wesentlichen dadurch, dass anstelle des Floating-Gates 312 als Ladungsspeicherbereich eine Siliziumnitrid-Schicht (Si₃N₄) 601 zwischen zwei Siliziumoxid-Teilschichten des elektrischen Isolationsbereichs 311 sandwichartig eingebettet ist, wodurch zwischen dem Kanal-Bereich 304 und dem Steuergate 313 eine ONO-Schichtenfolge (Siliziumoxid-Siliziumnitrid-Siliziumoxid) gebildet ist. Bei der Speicherzelle 600 wird die Siliziumnitrid-Schicht 601 der ONO-Schichtenfolge als "Charge Trapping Layer", das heißt als elektrisch isolierender Ladungsspeicherbereich verwendet. Das Injizieren von Elektronen in die Siliziumnitrid-Schicht 601 erfolgt ähnlich wie das Injizieren von Elektronen in das Floating-Gate 312 bei der Speicherzelle 300, wobei aufgrund der elektrisch isolierenden Eigenschaft von Siliziumnitrid-Material die in die Siliziumnitrid-Schicht 601 eingebrachten elektrischen Ladungsträger an dem jeweiligen Injektionsort innerhalb der Siliziumnitrid-Schicht 601 verbleiben und sich nicht frei auf dem Ladungsspeicherbereich verteilen.

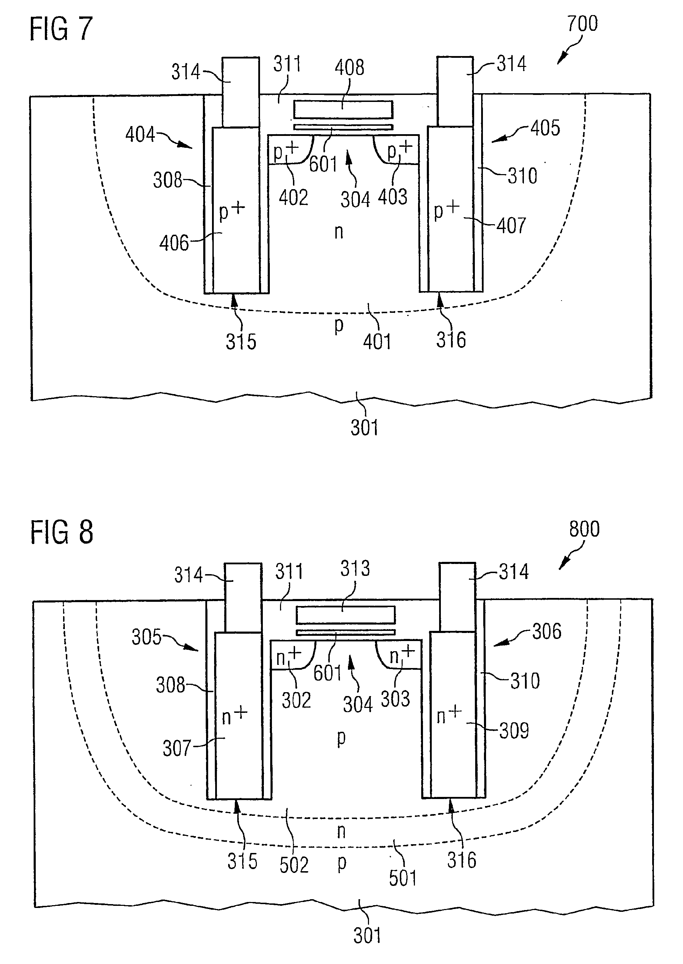

Im Weiteren wird bezugnehmend auf **Fig.7** eine Speicherzelle 700 gemäß einem fünften Ausführungsbeispiel der Erfindung beschrieben.

Die Speicherzelle 700 unterscheidet sich von der in Fig.4 gezeigten Speicherzelle 400 dadurch, 1 dass das Floating-Gate 312 aus Fig.4 durch die Siliziumnitrid-Schicht 601 ersetzt ist.

Im Weiteren wird bezugnehmend auf **Fig.8** eine Speicherzelle 800 gemäß einem sechsten Ausführungsbeispiel der Erfindung beschrieben.

Die Speicherzelle 800 unterscheidet sich von der in Fig.5 gezeigten Speicherzelle 500 dadurch, dass das Floating-Gate 312 durch die Siliziumnitrid-Schicht 601 ersetzt ist.

Im Weiteren wird bezugnehmend auf **Fig.11** eine Speicherzelle 1100 gemäß einem siebten Ausführungsbeispiel der Erfindung beschrieben.

Die in Fig.11 gezeigte Speicherzelle 1100 unterscheidet sich von der in Fig.6 gezeigten Speicherzelle 600 im Wesentlichen dadurch, 1 dass anstelle nur eines Speicher-Feldeffekttransistors in Fig.6 gemäß Fig.11 ein erster Speicher-Feldeffekttransistor 1101 und mindestens ein zweiter Speicher-Feldeffekttransistor 1102 ausgebildet sind. Die Steuergates 313 des ersten bzw. des zweiten Speicher-Feldeffekttransistors 1101, 1102 sind separat ansteuerbar. Die Steuergates 313 der beiden Speicher-Feldeffekttransistoren 1101, 1102 sind voneinander räumlich getrennt und elektrisch separat ansteuerbar. Als Ladungsspeicherbereich weist die Speicherzelle 1100 eine ONO-Schichtenfolge 1103 auf, die gebildet ist aus einer ersten Siliziumoxid-Schicht 1104, einer Siliziumnitrid-Schicht 1105 als "Charge Trapping Layer" und einer zweiten Siliziumoxid-Schicht 1106.

Wie im Weiteren beschrieben, können mittels Anlegens vorgebbarer elektrischer Potentiale an die Anschlüsse der Speicherzelle 1100 Elektronen aus den Grabenstrukturen 305, 306 in die ONO-Schichtenfolge 1103 eingebracht werden können.

Gemäß dem in Fig.11 gezeigten Szenario ist an die n⁺-dotierten Polysilizium-Kerne 307, 309 der Grabenstrukturen 305, 306 jeweils ein negatives elektrisches Potential von z.B. -2Volt angelegt. An die Steuergates 313 des ersten und des zweiten Speicher-Feldeffekttransistors 1101, 1102, ist jeweils ein positives elektrisches Potential von z.B. +8Volt angelegt. Aufgrund der Potentialverhältnisse werden die aus den Dioden 315, 316 austretenden Elektronen zu den Kanal-Bereichen 304 der Speicher-Feldeffekttransistoren 1101, 1102 hin beschleunigt und in einem ersten Ladungsspeicherbereich 1107 und in einem zweiten Ladungsspeicherbereich 1108 der ONO-Schichtenfolge 1103 injiziert. Dieser Verfahrensschritt kann als ein Rücksetzen der Speicherinhalte der Feldeffekttransistoren 1101, 1102 bezeichnet werden.

Um in einen ausgewählten der ersten und zweiten Ladungsspeicherbereiche 1107 oder 1108 selektiv eine Speicherinformation von einem Bit zu programmieren, werden mittels Fowler-Nordheim-Tunnelns die in den jeweiligen Ladungsspeicherbereich 1107 oder 1108 mittels Injizierens heißer Elektronen eingebrachte Elektronen selektiv entfernt. Hierbei kann die sehr gute räumliche Auflösung des Fowler-Nordheim-Programmierens beim Einbringen/Entfernen von Ladungsträgern vorteilhaft genutzt werden.

Somit ist es bei der Speicherzelle 1100 möglich, unterschiedliche Speicher-Feldeffekttransistoren der Speicherzelle voneinander separat zu beschreiben. Dadurch kann die Speicherzelle der Erfindung als Mehrfach-Bit-Speicherzelle, beispielsweise als 2-Bit-Speicherzelle wie in Fig.11, realisiert sein.

Anschaulich können unterschiedliche Bereiche der ONO-Schichtenfolge 1103 als Ladungsspeicherschicht zum separaten Einbringen/Entfernen von elektrischen Ladungsträgern und somit als separate Informations-Bit-Speicherbereiche betrieben werden.

Eine vorteilhafte Betriebsweise einer solchen Speicherzelle 1100 besteht darin, dass zunächst alle Speicherzellen zurückgesetzt werden, indem Ladungsträger (z.B. mittels Tunnels heißer Ladungsträger) in die gesamte Ladungsspeicherschicht 1103 injiziert werden. Das Programmieren von Information erfolgt dann unter Verwendung eines ortsspezifischen Entfernens von Ladungsträgern aus einem ausgewählten Bereich der Ladungsspeicherschicht, z.B. mittels Fowler-Nordheim-Tunnelns.

Alternativ kann die Injektion heißer Ladungsträger selektiv erfolgen, indem man das eine Steuergate wie beschrieben auf ein positives Potential legt, das andere Steuergate auf Substrat- bzw. Wannenpotential belässt. Hierdurch werden die Ladungsträger selektiv nur zu einem Gate beschleunigt, wodurch eine selektive Programmierung erzielt wird.

Desweiteren sei angemerkt, dass die in Fig.11 beschriebene Implementierung ebenfalls mit den in Fig.7 und Fig.8 vorgestellten Wannenkonstruktionen analog möglich ist.

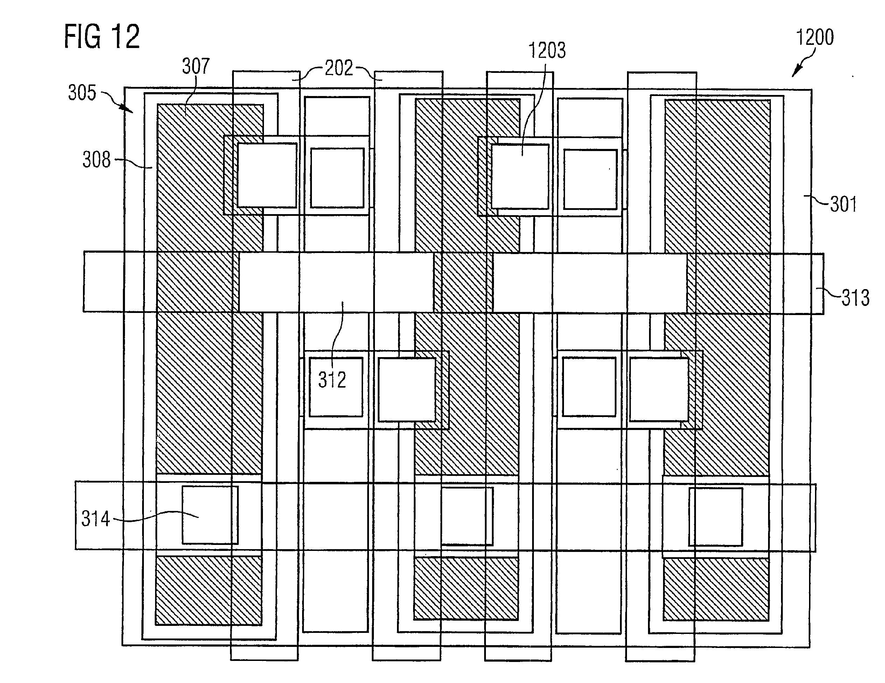

Im Weiteren wird bezugnehmend auf **Fig.12** eine schematische Layout-Ansicht (Draufsicht) einer Speicherzellen-Anordnung 1200 gemäß einem Ausführungsbeispiel der Erfindung beschrieben.

Die Speicherzellen-Anordnung 1200 enthält eine Vielzahl von Speicherzellen, wie sie zum Beispiel in Fig.3 gezeigt sind. Zur Übersichtlichkeit sind in Fig.12 Bezugszeichen aus Fig.3 eingefügt. Die Speicherzellen-Anordnung 1200 ist SNOR-Architektur realisiert.

Das Steuergate 313 ist in Fig.12 für eine Zeile von Speicherzellen gemeinsam ausgeführt und ist somit ähnlich wie eine Leiterbahn realisiert. Mittels einer Substrat-Kontaktierung (nicht in Fig. 12 gezeichnet)kann dem Substrat 301 ein definiertes elektrisches Potential bereitgestellt werden. Ferner sind Leiterbahnen 1202 und Leiterbahn-Vias 1203 bzw. Kontaktlöcher 1201 gezeigt, mittels welcher die Source-/Drain-Bereiche kontaktierbar sind.

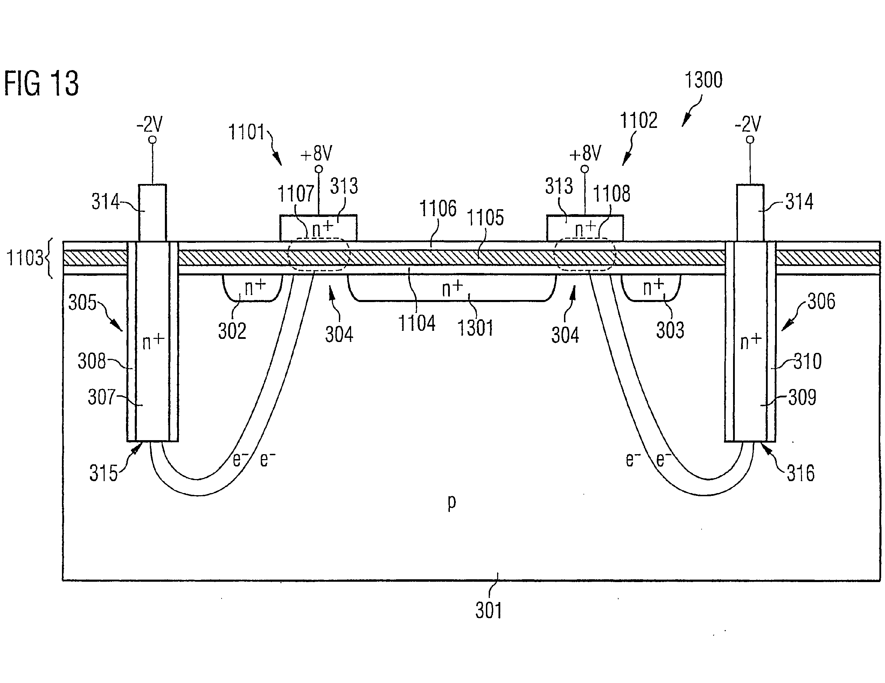

Im Weiteren wird bezugnehmend auf **Fig.13** eine Speicherzelle 1300 gemäß einem achten Ausführungsbeispiel der Erfindung beschrieben.

Die Speicherzelle 1300 unterscheidet sich von der Speicherzelle 1100 im Wesentlichen dadurch, dass der gemäß Fig.11 rechte, d.h. der zweite Source-/Drain-Bereich 303 des ersten Speicher-Feldeffekttransistors 1101 mit dem gemäß Fig.11 linken, d.h. zweiten Source-/Drain-Bereich 302 des zweiten Speicher-Feldeffekttransistors 1102 als gemeinsamer Source-/Drain-Bereich 1301 ausgeführt ist. Der gemeinsame Source-/Drain-Bereich 1301 stellt somit ein zusammenhängendes Implantationsgebiet dar. Eine solche Zusammenlegung zweier Source-/Drain-Bereiche zweier benachbarter Speicherzellen kann auch für eine Speicherzellen-Anordnung mit einer Vielzahl von Speicherzellen realisiert werden. Legt man die Source/Drain-Gebiete 303/302 zusammen, erhält man anschaulich eine Art NAND-Struktur.

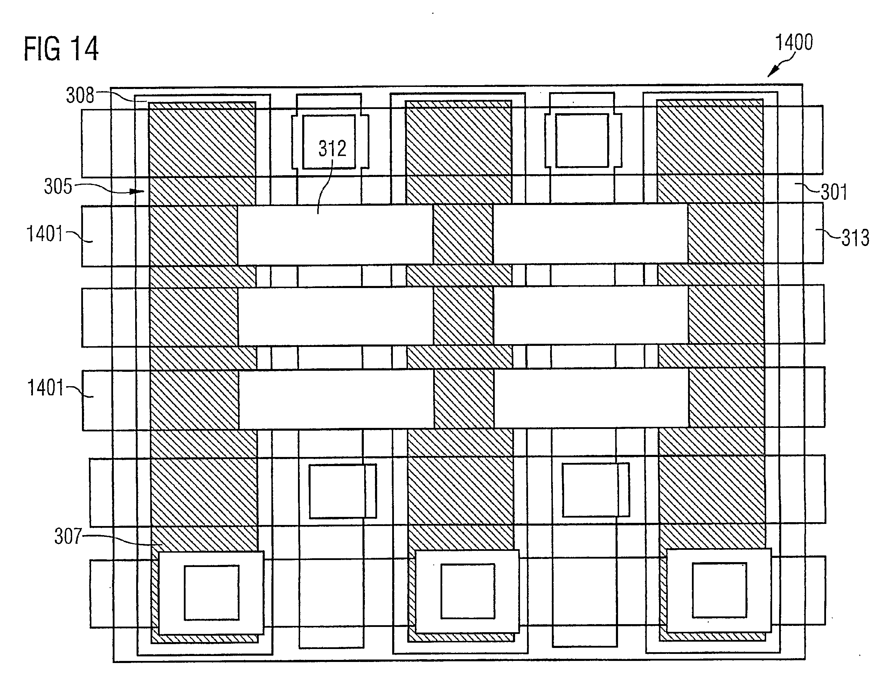

Im Weiteren wird bezugnehmend auf **Fig.14** eine schematische Layout-Ansicht (Draufsicht) einer Speicherzellen-Anordnung 1400 gemäß einem anderen Ausführungsbeispiel der Erfindung beschrieben, wobei in der Speicherzellen-Anordnung Leiterbahnen 1401 vorgesehen sind.

Die Speicherzellen-Anordnung 1400 aus Fig.14 stellt ein schematisches Layout dar, aus dem ersichtlich ist, wie erfindungsgemäße Speicherzellen in eine NAND-Struktur integriert werden können. Eine Integration in andere Anordnungen (z.B. NOR,...) ist auch möglich. Daher sollen die gezeigten Beispiele nur zur Veranschaulichung dienen, 1 ohne dass eine Beschränkung auf eine spezielle Speicheranordnung vorgenommen ist.

In diesem Dokument sind folgende Veröffentlichungen zitiert:
[1] US 2003/0006448 A1
[2] US 6,518,126 B2
[3] US 6,366,499 B1
[4] US 6, 329, 246 B1

### Bezugszeichenliste

100 Floating-Gate-Speicherzelle
101 p-dotiertes Silizium-Substrat
102 n-dotierte Wanne
103 p-dotierte Wanne
104 erster Source-/Drain-Bereich
105 zweiter Source-/Drain-Bereich
106 Kanal-Bereich
107 elektrisch isolierender Bereich
108 Floating-Gate-Bereich
109 Steuergate
110 STI-Bereich
111 Kontaktierungselemente
112 pn-Übergang
200 Test-Ariordnung
201 p-dotiertes Silizium-Substrat
202 Feldeffekttransistor
203 erster Source-/Drain-Bereich
204 zweiter Source-/Drain-Bereich
205 elektrisch isolierender Bereich
206 Gate-Bereich
207 Kontaktierungselemente
208 Kanal-Bereich
209 n⁺-dotierter Bereich
210 anderes Kontaktierungselement
300 Speicherzelle
301 p-dotiertes Substrat
302 erster n⁺-dotierter Source-/Drain-Bereich
303 zweiter n⁺-dotierter Source-/Drain-Bereich
304 Kanal-Bereich
305 erste Grabenstruktur
306 zweite Grabenstruktur
307 erster n⁺-dotierter Polysilizium-Kern
308 erster Siliziumoxid-Mantel
309 zweiter n⁺-dotierter Polysilizium-Kern
310 zweiter Siliziumoxid-Mantel
311 elektrischer Isolationsbereich
312 Floating-Gate
313 n⁺-Steuergate
314 Kontaktierungselemente
315 erster pn-Übergang
316 zweiter pn-Übergang
400 Speicherzelle
401 n-Wannenbereich
402 erster p⁺-dotierter Source-/Drain-Bereich
403 zweiter p⁺-dotierter Source-/Drain-Bereich
404 erste Grabenstruktur
405 zweite Grabenstruktur
406 erster p⁺-dotierter Polysilizium-Kern
407 zweiter n⁺-dotierter Polysilizium-Kern
408 p⁺-Steuergate
500 Speicherzelle
501 n-dotierter großer Wannenbereich
502 p-dotierter kleiner Wannenbereich
600 Speicherzelle
601 Siliziumnitrid-Schicht
700 Speicherzelle
800 Speicherzelle
900 erste Strompfade
901 zweite Strompfade
902 erste Elektronen
903 zweite Elektronen
1000 erste Strompfade
1001 zweite Strompfade
1002 erste Löcher
1003 zweite Löcher
1100 Speicherzelle
1101 erster Speicher-Feldeffekttransistor
1102 zweiter Speicher-Feldeffekttransistor
1103 ONO-Schichtenfolge
1104 erste Siliziumoxid-Schicht
1105 Siliziumnitrid-Schicht
1106 zweite Siliziumoxid-Schicht
1107 erster Ladungsspeicherbereich
1108 zweiter Ladungsspeicherbereich
1200 Speicherzellen-Anordnung
1202 Leiterbahnen
1203 Leiterbahn-Via
1300 Speicherzelle
1301 gemeinsamer Source-/Drain-Bereich
1400 Speicherzellen-Anordnung
1401 Leiterbahnen

## Patentansprüche

1. Speicherzelle
- mit einem Substrat (301), das Ladungsträger eines ersten Leitungstyps enthält;
- mit einem ersten Source-/Drain-Bereich (302) in einem ersten Oberflächenbereich des Substrats und mit einem zweiten Source-/Drain-Bereich (303) in einem zweiten Oberflächenbereich des Substrats;
- mit einem Kanal-Bereich (304) in einem Oberflächenbereich des Substrats zwischen dem ersten und dem zweiten Source- /Drain-Bereich;
- mit einem Ladungsspeicherbereich (312) über dem Kanal-Bereich;
- mit einem Steuergate (313) über dem Ladungsspeicherbereich, welches von dem Ladungsspeicherbereich elektrisch isoliert ist;
- mit einer in dem Substrat gebildeten Grabenstruktur (305,306), die Ladungsträger lieferndes Material (307,309) mit Ladungsträgern eines zweiten Leitungstyps und einen Isolationsbereich (308) zwischen dem Substrat und zumindest einem Teil des Ladungsträger liefernden Materials aufweist, wobei die Grabenstruktur zumindest teilweise mit einer Shallow-Trench-Seitenwandisolation versehen ist;
- wobei der erste Leitungstyp von dem zweiten Leitungstyp unterschiedlich ist, so dass zwischen dem Substrat und dem Ladungsträger liefernden Material der Grabenstruktur ein Dioden-Übergang (315,316) gebildet ist;
- wobei die Speicherzelle derart eingerichtet ist, dass mittels Anlegens vorgebbarer elektrischer Potentiale an die Speicherzelle elektrische Ladungsträger aus dem Ladungsträger liefernden Material der Grabenstruktur in den Ladungsspeicherbereich einbringbar sind.

2. Speicherzelle nach Anspruch 1,
bei der sich die Grabenstruktur tiefer in das Substrat hineinerstreckt als der erste und der zweite Source-/Drain-Bereich.

3. Speicherzelle nach Anspruch 2, bei der sich die Grabenstruktur mindestens um einen Faktor drei tiefer in das Substrat hineinerstreckt als der erste und der zweite Source-/Drain-Bereich.

4. Speicherzelle nach einem der Ansprüche 1 bis 3, bei der sich die Grabenstruktur in im Wesentlichen vertikaler Richtung zu der Oberfläche des Substrats erstreckt.

5. Speicherzelle nach einem der Ansprüche 1 bis 4, bei der die Grabenstruktur seitlich von zumindest einem der Source-/Drain-Bereiche und außerhalb des Kanal-Bereichs gebildet ist.

6. Speicherzelle nach einem der Ansprüche 1 bis 5, mit zwei Grabenstrukturen, von denen eine seitlich des ersten Source-/Drain-Bereichs und außerhalb des Kanal-Bereichs angeordnet ist und die andere seitlich des zweiten Source-/Drain-Bereichs und außerhalb des Kanal-Bereichs angeordnet ist.

7. Speicherzelle nach einem der Ansprüche 1 bis 6, bei der die Grabenstruktur einen elektrisch isolierenden Mantelbereich an zumindest einem Teil der Seitenwand des Grabens und einen in den Graben eingefüllten elektrisch leitfähigen Kernbereich aufweist derart, dass elektrische Ladungsträger aus der Grabenstruktur nur von solchen Bereichen in das Substrat austreten können, in welchen der Kernbereich von einer Ummantelung mit dem Mantelbereich frei ist, oder in solchen Bereichen, in welchen der Mantelbereich eine ausreichend geringe Dicke aufweist, um einen Tunnelstrom zu ermöglichen.

8. Speicherzelle nach einem der Ansprüche 1 bis 7, bei welcher der Ladungsspeicherbereich ein Floating-Gate ist.

9. Speicherzelle nach Anspruch 8, bei der das Floating-Gate Polysilizium aufweist.

10. Speicherzelle nach Anspruch 8 oder 9, bei der zwischen dem Substrat und dem Floating-Gate eine Gate-isolierende Schicht angeordnet ist.

11. Speicherzelle nach einem der Ansprüche 1 bis 7, bei welcher der Ladungsspeicherbereich ein elektrisch isolierender Ladungsspeicherbereich ist.

12. Speicherzelle nach Anspruch 11, bei welcher der elektrisch isolierende Ladungsspeicherbereich
• eine Siliziumoxid-Siliziumnitrid-Siliziumoxid-Schichtenfolge;
• Siliziumnitrid;
• Aluminiumoxid;
• Yttriumoxid;
• Lanthanoxid;
• Hafniumoxid;
• zirkoniumoxid;
• eine Siliziumoxid-Aluminiumoxid-Siliziumoxid-Schichtenfolge;
• eine Siliziumoxid-Yttriumoxid-Siliziumoxid-Schichtenfolge;
• eine Siliziumoxid-Lanthanoxid-Siliziumoxid-Schichtenfolge;
• eine Siliziumoxid-Hafniumoxid-Siliziumoxid-Schichtenfolge;
• eine Siliziumoxid-Zirkoniumoxid-Schichtenfolge; und/oder
• eine andere Schichtenfolge, die eine dauerhafte Ladungsspeicherung ermöglicht
aufweist oder daraus besteht.

13. Speicherzelle nach einem der Ansprüche 1 bis 12, bei der das Substrat einen die Ladungsträger des ersten Leitungstyps aufweisenden Wannenbereich aufweist und einen Ladungsträger des zweiten Leitungstyps aufweisenden Bereich aufweist, wobei in dem Wannenbereich die Komponenten der Speicherzelle gebildet.sind.

14. Speicherzelle nach einem der Ansprüche 1 bis 13, die eine Mehrzahl von räumlich getrennten und elektrisch separat ansteuerbaren Steuergates aufweist derart, dass mittels Anlegens vorgebbarer elektrischer Potentiale an mindestens ein ausgewähltes der Steuergates-elektrische Ladungsträger von der Grabenstruktur in einen an das mindestens eine ausgewählte Steuergate benachbarten Bereich des Ladungsspeicherbereichs einbringbar sind.

15. Speicherzelle nach einem der Ansprüche 1 bis 14, bei dem die Ladungsträger des ersten Leitungstyps und/oder die Ladungsträger des zweiten Leitungtyps Dotieratome sind.

16. Speicherzellen-Anordnung mit einer Mehrzahl von in dem Substrat integrierten Speicherzellen nach einem der Ansprüche 1 bis 15.

17. Speicherzellen-Anordnung nach Anspruch 16, die derart ausgebildet ist, dass mittels der elektrisch isolierenden Mantelbereiche unterschiedliche Speicherzellen voneinander elektrisch entkoppelt sind.

18. Verfahren zum Herstellen einer Speicherzelle, bei dem,
- ein erster source-/Drain-Bereich (302) in einem ersten Oberflächenbereich eines Substrats, das Ladungsträger eines ersten Leitungstyps enthält, und ein zweiter Source- Drain-Bereich (303) in einem zweiten Oberflächenbereich des Substrats gebildet werden;
- ein Kanal-Bereich (304) in einem Oberflächenbereich des Substrats zwischen dem ersten und dem zweiten Source-/Drain-Bereich gebildet wird;
- ein Ladungsspeicherbereich (312) über dem Kanal-Bereich gebildet wird;
- ein Steuergate (313) über dem Ladungsspeicherbereich gebildet wird, welches von dem Ladungsspeicherbereich elektrisch isoliert wird;
- eine in dem Substrat angeordnete Grabenstruktur (305,306) gebildet wird die Ladungsträger lieferndes Material (307,309) mit Ladungsträgern eines zweiten Leitungstyps und einen Isolationsbereich (308) zwischen dem Substrat und zumindest einem Teil des Ladungsträger liefernden Materials aufweist, wobei die Grabenstruktur zumindest teilweise mit einer Shallow-Trench-Seitenwandisolation versehen ist;
- wobei der erste Leitungstyp von dem zweiten, Leitungstyp unterschiedlich eingestellt wird, so dass zwischen dem Substrat und dem Ladungsträger liefernden Material der Grabenstruktur ein Dioden-Übergang (315,316) gebildet wird;
- wobei die Speicherzelle derart eingerichtet wird, dass mittels Anlegens vorgebbarer elektrischer Potentiale an die Speicherzelle elektrische Ladungsträger aus dem Ladungsträger liefernden Material der Grabenstruktur in den Ladungsspeicherbereich einbringbar sind.

19. Verfahren nach Anspruch 18,
bei dem die Grabenstruktur gebildet wird, indem
• zumindest ein Graben in dem Substrat gebildet wird;
• ein elektrisch isolierender Mantelbereich zumindest an zumindest einem Teil der Oberfläche des mindestens einen Grabens gebildet wird;
• ein elektrisch leitfähiger Kernbereich in dem mindestens einen Graben gebildet wird.

20. Verfahren nach Anspruch 18,
bei dem die Grabenstruktur gebildet wird, indem
• zumindest ein Graben in dem Substrat gebildet wird;
• der Graben mit elektrisch isolierendem Material gefüllt wird;
• ein Teil des elektrisch isolierenden Materials aus dem Graben entfernt wird, wodurch der elektrisch isolierende Mantelbereich gebildet wird;
• ein elektrisch leitfähiger Kernbereich in dem mindestens einen Graben gebildet wird.

## Claims

1. Storage cell, comprising
- a substrate (301), containing charge carriers of a first conduction type;
- a first source-/drain region (302) in a first surface region of the substrate and a second source-/drain-region (303) in a second surface region of the substrate;
- a channel region (304) in a surface region of the substrate between the first and the second source/drain region;
- a charge storage region (312) above the channel region;
- a control gate (313) above the charge storage region, which is electrically insulated from the charge storage region;
- a trench structure (305, 306) formed in the substrate, comprising material (307, 309) providing charge carriers having charge carriers of a second conduction type and an insulating region (308) between the substrate and between at least a part of the material providing charge carriers, wherein the trench structure is at least partially provided with a shallow trench side wall insulation;
- wherein the first conduction type is different from the second conduction type such that a diode junction (315, 316) is formed between the substrate and the charge carriers providing material of the trench structure;
- wherein the storage cell is configured such that electrical charge carriers from the charge carrier providing material of the trench structure are insertable into the charge storage region by applying presettable electrical potentials to the storage cell.

2. Storage cell according to claim 1,
wherein the trench structure extends deeper into the substrate than the first and the second source-/drain region.

3. Storage cell according to claim 2,
wherein the trench structure extends into the substrate at least by a factor 3 deeper than the first and the second source-/drain region.

4. Storage cell according to one of the claims 1 to 3,
wherein the trench structure extends in an essentially vertical direction relative to the surface structure of the substrate.

5. Storage cell according to one of the claims 1 to 4,
wherein the trench structure is formed on a side of at least one of the source-/drain regions and outside the channel region.

6. Storage cell according to one of the claims 1 to 5,
having two trench structures, one of which is arranged on a side of the first source-/drain region and outside the channel region und the other one of which is arranged on a side of the second source-/drain region and outside the channel region.

7. Storage cell according to one of the claims 1 to 6,
wherein the trench structure comprises an electrically insulating coating region on at least a part of the sidewall of the trench and an electrically conductive core region filled into the trench such that electrical charge carriers from the trench structure are only allowed to leak from such regions into the substrate, in which the core region is free from a coating by the coating region, or in such regions, in which the coating region comprises a sufficient small thickness for enabling a tunnel current.

8. Storage cell according to one of the claims 1 to 7,
wherein the charge storage region is a floating-gate.

9. Storage cell according to claim 8,
wherein the floating-gate comprises polysilicon.

10. Storage cell according to claim 8 or 9,
wherein a gate-insulating layer is arranged between the substrate and the floating-gate.

11. Storage cell according to one of the claims 1 to 7,
wherein the charge storage region is an electrically insulating charge storage region.

12. Storage cell according to claim 11,
wherein the electrically insulating charge storage region comprises or consists of
- a silicon oxide - silicon nitride - silicon oxide layer sequence;
- silicon nitride;
- aluminium oxide;
- yttrium oxide;
- lanthanum oxide;
- hafnium oxide;
- zirconium oxide;
- a silicon oxide - aluminium oxide - silicon oxide layer sequence;
- a silicon oxide - yttrium oxide - silicon oxide layer sequence;
- a silicon oxide - lanthanum oxide - silicon oxide layer sequence;
- a silicon oxide - hafnium oxide - silicon oxide layer sequence;
- a silicon oxide - zirconium oxide layer sequence; and/or
- another layer sequence, which enables a permanent charge storage.

13. Storage cell according to one of the claims 1 to 12,
wherein the substrate comprises a well region comprising the charge carriers of the first conduction type and a region comprising the charge carriers of the second conduction type,
wherein the components of the storage cell are formed in the well region.

14. Storage cell according to one of the claims 1 to 13,
comprising a plurality of spatially separated and electrically separately controllable control gates such that electrical charge carriers from the trench structure are insertable into a region adjacent to the at least one selected control gate by applying presettable electrical potentials to at least selected one of the control gates.

15. Storage cell according to one of the claims 1 to 14,
wherein the charge carriers of the first conduction type and/or the charge carriers of the second conduction type are doping atoms.

16. Storage cell arrangement,
comprising a plurality of storage cells integrated in the substrate according to one of the claims 1 to 15.

17. Storage cell arrangement according to claim 16,
which is formed in such a manner that different storage cells are electrically decoupled from each other by the electrically insulating coating regions.

18. Method for manufacturing a storage cell,
wherein
- a first source-/drain region (302) is formed in a first surface region of a substrate, which contains charge carriers of a first conduction type, and a second source-/drain-region (303) is formed in a second surface region of the substrate;
- a channel region (304) is formed in a surface region of the substrate between the first and the second source-/drain region;
- a charge storage region (312) is formed above the channel region;
- a control gate (313), which is electrically insulated from the charge storage region, is formed above the charge storage region;
- a trench structure (305, 306) arranged in the substrate is formed, which comprises material (307, 309) providing charge carriers having charge carriers of a second conduction type and an insulating region (308) between the substrate and between at least a part of the material providing charge carriers,
wherein the trench structure is at least partially provided with a shallow trench side wall insulation;
- wherein the first conduction type is adjusted differently from the second conduction type such that a diode-junction (315, 316) is formed between the substrate and the charge carriers providing material of the trench structure;
- wherein the storage cell is configured such that electrical charge carriers from the charge carrier providing material of the trench structure are insertable into the charge storage region by applying presettable electrical potentials to the storage cell.

19. Method according to claim 18,
wherein the trench structure is formed by
- forming at least one trench in the substrate;
- forming an electrically insulating coating region on at least one part of the surface of the at least one trench;
- forming an electrically conductive core region in the at least one trench.

20. Method according to claim 18,
wherein the trench structure is formed by
- forming at least one trench in the substrate;
- filling the trench with electrically insulating material;
- removing a part of the electrically insulating material from the trench, whereby the electrically insulating coating region is formed;
- forming an electrically conductive core region in the at least one trench.

## Revendications

1. Cellule de mémoire
- comprenant un substrat (301) qui comporte des porteurs de charge d'un premier type de conductivité;
- comprenant une zone (302) de source/drain dans une première partie de surface du substrat et comprenant une deuxième zone (303) de source/drain dans une deuxième partie de surface du substrat ;
- comprenant une zone (304) de canal dans une partie de surface du substrat entre la première et la deuxième zone de source/drain ;
- comprenant une zone (312) d'accumulation de charges au-dessus de la zone de canal ;
- comprenant une grille (313) de commande au-dessus de la zone d'accumulation de charges et isolée électriquement de la zone d'accumulation de charges ;
- comprenant une structure (305, 306) de sillons formée dans le substrat et ayant du matériau (307, 309) fournissant des porteurs de charge et ayant des porteurs de charge d'un deuxième type de conductivité et une zone (308) isolante entre le substrat et au moins une partie du matériau fournissant des porteurs de charge, dans laquelle la structure de sillons dont est munie au moins en partie d'un isolant de paroi shallow-trench ;
- dans laquelle le premier type de conductivité est différent du deuxième type de conductivité de manière à former une jonction (315, 316) de diode entre le substrat et le matériau de la structure de sillons fournissant des porteurs de charge ;
- dans laquelle la cellule de mémoire est telle, qu'en appliquant des potentiels électriques pouvant être prescrits à la cellule de mémoire, des porteurs de charge électrique peuvent être introduits du matériau de la structure de sillons fournissant des porteurs de charge dans la zone d'accumulation de charges.

2. Cellule de mémoire suivant la revendication 1,
dans laquelle la structure de sillons pénètre plus profondément dans le substrat que la première zone et la deuxième zone de source/drain.

3. Cellule de mémoire suivant la revendication 2,
dans laquelle la structure de sillons pénètre au moins plus profondément dans le substrat d'un facteur de trois que la première et la deuxième zones de source/drain.

4. Cellule de mémoire suivant l'une des revendications 1 à 3,
dans laquelle la structure de sillons s'étend dans la direction sensiblement verticale par rapport à la surface du substrat.

5. Cellule de mémoire suivant l'une des revendications 1 à 4, dans laquelle la structure de sillons est formée latéralement à au moins l'une des zones de source/drain et en dehors de la zone de canal.

6. Cellule de mémoire suivant des revendications 1 à 5, comprenant deux structures de sillons, dont l'une est disposée latéralement à la première zone de source/drain et en dehors de la zone de canal et dont l'autre est disposée latéralement à la deuxième zone de source/drain et à l'extérieur de la zone de canal.

7. Cellule de mémoire suivant l'une des revendications 1 à 6, dans laquelle la structure de sillons a une zone de surface latérale isolante électriquement sur au moins une partie de la paroi latérale des sillons et une zone de coeur conductrice de l'électricité garnie dans les sillons de façon à ce que des porteurs de charge électrique puissent sortir de la structure de sillons seulement des parties du substrat dans lesquelles la zone de coeur n'est pas entourée de la partie de surface latérale où dans des parties dans lesquelles la partie de surface latérale a une épaisseur suffisamment petite pour permettre un courant de tunnel.

8. Cellule de mémoire suivant l'une des revendications 1 à 7, dans laquelle la zone d'accumulation de charges est, une grille flottante.

9. Cellule de mémoire suivant la revendication 8,
dans laquelle la grille flottante comporte du polysilicium.

10. Cellule de mémoire suivant les revendications 8 et 9, dans laquelle une couche isolante de grille est déposée entre le substrat et la grille flottante.

11. Cellule de mémoire suivant l'une des revendications 1 à 7, dans laquelle la zone d'accumulation de charges est une zone d'accumulation de charges isolante du point de vue électrique.

12. Cellule de mémoire suivant la revendication 11,
dans laquelle la zone d'accumulation de charges isolante du point de vue électrique a :
• une succession de couches oxyde de silicium-nitrure de silicium-oxyde de silicium
• du nitrure de silicium ;
• de l'oxyde d'aluminium ;
• de l'oxyde d'yttrium ;
• de l'oxyde de lanthane ;
• de l'oxyde d'hafnium ;
• de l'oxyde de zirconium ;
• une succession de couches oxyde de silicium-oxyde d'aluminium-oxyde de silicium ;
• une succession de couches oxyde de silicium-oxyde d'yttriumoxyde de silicium ;
• une succession de couches oxyde de silicium-oxyde de lanthane-oxyde de silicium ;
• une succession de couches oxyde de silicium-oxyde d'hafniumoxyde de silicium ;
• une succession de couches oxyde de silicium-oxyde de zirconium ; et/ou
• une autre succession de couches, qui rend possible une accumulation permanente de charges
ou en est constituée.

13. Cellule de mémoire suivant l'une des revendications 1 à 12, dans laquelle le substrat a une partie de caisson comportant les porteurs de charge du premier type de conductivité et une partie ayant des porteurs de charge du deuxième type de conductivité, dans laquelle les composants de la cellule de mémoire sont formés dans la partie de caisson.

14. cellule de mémoire suivant l'une des revendications 1 à 13 qui a une multiplicité de grilles de commande séparées dans l'espace et pouvant être commandées séparément du point de vue électrique de façon à ce qu'en appliquant des potentiels électriques prescrits à au moins l'une sélectionnée des grilles de commande, on puisse introduire des porteurs de charge de la structure de sillons dans une partie, voisine de la au moins une grille de commande choisie, de la zone d'accumulation de charges.

15. Cellule de mémoire suivant l'une des revendications 1 à 14, dans laquelle les porteurs de charge du premier type de conductivité et/ou et les porteurs de charge du deuxième type de conductivité sont des atomes de dopage.

16. Dispositif à cellules de mémoire comprenant une multiplicité de cellules de mémoire intégrées dans le substrat suivant l'une des revendications 1 à 15.

17. Dispositif à cellules de mémoire suivant la revendication 16,
qui est constitué de façon à ce que des cellules de mémoire différentes soient découplées électriquement les unes des autres au moyen des parties de surfaces latérales isolantes du point de vue électrique.

18. Procédé de production d'une cellule de mémoire
dans lequel, 1
- On forme une première zone (302) de source/drain dans une première partie de surface d'un substrat, qui comporte des porteurs de charge d'un premier type de conductivité, et on forme une deuxième zone (303) de source/drain dans une deuxième partie de surface du substrat ;
- on forme une zone (304) de canal dans une partie de surface du substrat entre la première et la deuxième zones de source/drain ;
- on forme une zone (312) d'accumulation de charges au-dessus de la zone de canal ;
on forme une grille (313) de commande au-dessus de la zone d'accumulation de charges, grille qui est isolée du point de vue électrique de la zone d'accumulation de charges ;
- on forme une structure (305, 306) de sillons, qui est disposée dans le substrat et qui a du matériau (307, 309) fournissant des porteurs de charge et ayant des porteurs de charge d'un deuxième type de conductivité et une partie (308) isolante entre le substrat et au moins une partie du matériau fournissant des porteurs de charge, la structure de sillons étant munie au moins en partie d'un isolant de paroi latérale shallow-trench ;
- on fait en sorte que le premier type de conductivité soit différent du deuxième type de conductivité de manière à former une jonction (315, 316) de diode entre le substrat et le matériau de la structure de sillons fournissant les porteurs de charge ;
- on fait en sorte que la cellule de mémoire puisse, en appliquant des potentiels électriques pouvant être prescrits par la cellule de mémoire, faire passer les porteurs de charge électrique de la structure de sillons fournissant des porteurs de charge dans la zone d'accumulation de charges.

19. Procédé suivant la revendication 18, dans lequel
on forme la structure de sillons en
• formant au moins un sillon dans le substrat ;
• formant une partie de surface latérale isolante du point de vue électrique dans au moins une partie de la surface du au moins un sillon ;
• on forme une partie de coeur conductrice de l'électricité dans le au moins un sillon.

20. Procédé suivant la revendication 18, dans lequel
on forme la structure de sillons en
• formant au moins un sillon dans le substrat ;
• remplissant le sillon de matériau isolant du point de vue électrique ;
• éliminant une partie du matériau isolant du point de vue électrique du sillon en formant ainsi la partie de la surface latérale isolante électriquement ;
• formant une partie de coeur conductrice de l'électricité dans le au moins un sillon.
